# EUROPEAN PATENT SPECIFICATION

(11) **EP 3 187 556 B1**
(45) Date of publication and mention of the grant of the patent: **30.08.2023**
(21) Application number: 15835421.7
(22) Date of filing: 10.08.2015
(51) Int. Cl.: C08K 3/36, C09J 7/10, C09J 7/20, C09J 7/00, C09J 4/00, C09J 11/04, C09J 11/06, C09J 201/02, H01L 21/301, H01L 21/683, H01L 21/52, C08K 3/28, C08K 3/08

(54) **ADHESIVE FILM**
HAFTFOLIE
FILM ADHÉSIF

(30) Priority: 29.08.2014 JP 2014176348
(43) Date of publication of application: 05.07.2017
(73) Proprietor: Furukawa Electric Co., Ltd., Chiyoda-ku Tokyo (JP)
(72) Inventor: AOYAMA, Masami, Tokyo 100-8322 (JP); KIRIKAE, Noriyuki, Tokyo 100-8322 (JP)
(74) Representative: Hermann, Felix
(86) International application number: PCT/JP2015/072717
(87) International publication number: WO 2016/031554

(56) References cited:
- WO-A1-2007/070065
- WO-A1-2009/123608
- WO-A2-2010/019832
- JP-A- 2008 501 826
- US-A- 6 121 358
- US-A1- 2005 267 254
- US-A1- 2011 018 127
- Akzo Nobel: "Initiators for high polymers", , 1 June 2006 (2006-06-01), XP055689416, Internet Retrieved from the Internet: URL:http://www.neochemical.kz/File/Akzo_Da ta_110407-Initiators_for_High_Polymers.pdf [retrieved on 2020-04-27]
- Gmbh Pergan: "Polymerization of monomers with peroxides", , 1 October 2019 (2019-10-01), XP055689425, Internet Retrieved from the Internet: URL:https://www.pergan.com/files/downloads /Polymerization_HP_EN.pdf [retrieved on 2020-04-27]

## Description

### TECHNICAL FIELD

The present invention relates to an adhesive film, in particular, an adhesive film that is suitable for the production of electronic equipments, integrated circuits, semiconductor devices, passive devices, solar batteries, solar modules, or light emitting diodes.

### Background Art

In recent years, with the advancement in miniaturization and increase in functionality of electronic devices, enhancement of the mounting efficiency within a limited mounting region is being required for the structure of semiconductor packages installed inside such devices. For example, instead of quad flat packages with peripheral terminal array, chip size packages and ball grid arrays with surface terminal array are increasing. Further, the appearance of stacked packages etc., which aim at adding value and increasing memory capacity to the memories installed into portable equipments etc. by installing multiple semiconductor devices into a single package, is a typical example.

In view of such demand for high density mounting, components used inside a semiconductor package is becoming thinner. In a stacked package, in order to laminate more semiconductor devices within the same package size, various components such as the semiconductor device, interposer substrate, sealing resin, and die-attaching materials for adhering the semiconductor device and interposer substrate are becoming thinner. On the other hand, such thinning of the components used inside a semiconductor package cause curving of the semiconductor chips and substrates to occur, due to the difference in linear expansion coefficients of the semiconductor chip, adhesive, and resist substrate, etc., leading to concerns of decrease in wire bonding accuracy and deterioration in reflow resistance.

In order to solve the problem of curving caused by the difference in the linear expansion coefficients, inventions that aim at reducing curving by adding an inorganic filler into the adhesive and controlling its content and particle size have been disclosed. (For example, see Patent Documents 1 and 2.) However, although the linear expansion coefficient of the adhesive can be decreased by increasing the content of the inorganic filler, the elastic modulus increases at the same time, adding large stress on the semiconductor chip that is bonded, causing problems of peeling and cracking to occur easily and diminishing the reliability of the semiconductor device.

### RELATED ART

### Patent Documents

[Patent Document 1] JP-A-2010-028087
[Patent Document 2] JP-A-2011-228642
[Patent Document 3] US 2005/267254 A1
[Patent Document 4] WO 2010/019832 A2

### SUMMARY

The present invention was made in view of the above problems, and its object is to provide a highly reliable adhesive film that does not add large stress on the adherend, that can also mitigate curving due to the difference in linear expansion coefficients of the adherends.

That is, the present invention provides an adhesive film, which comprises (A) a curable resin with a structure containing an alicyclic hydrocarbon with 5 to 8 carbons, which is substituted by at least 4 alkyl groups of 4 to 12 carbons, which further contains at least one curable part, and (B) a polymerization initiator with a one-hour half-life temperature of 140°C or higher, wherein (A) comprises the structure shown by the following General Formula (1). General Formula (1) 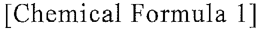 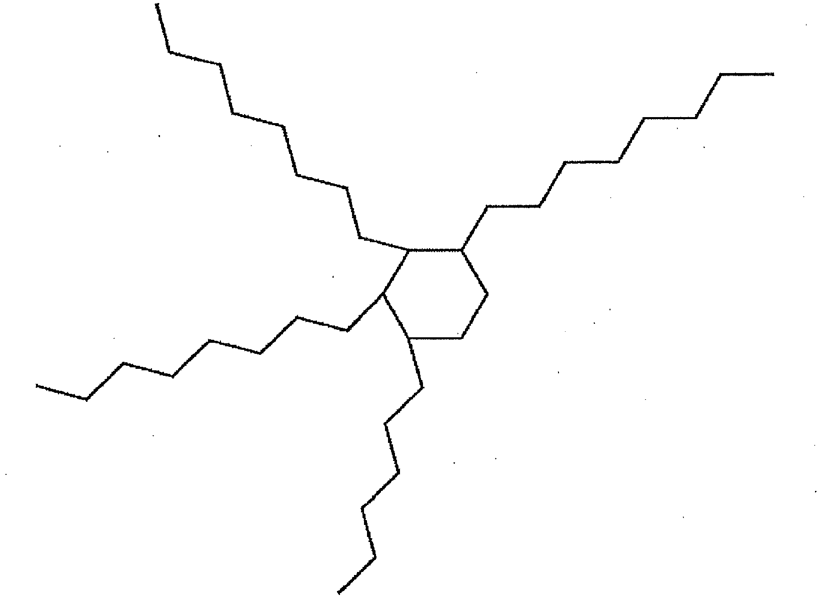 and wherein the content of (A) is 50% by mass or more of the resin component constituting the film.

Furthermore, the present invention relates to the above-described adhesive film, which further comprises a filler.

In addition, the present relation relates to an adhesive film with dicing tape, which comprises the above-described adhesive film laminated on to a dicing tape.

### Effect of the Invention

The present invention successfully provides a highly reliable adhesive film that shows excellent stress relaxation and moisture resistance, as well as a semiconductor device that utilizes such an adhesive film.

### BRIEF DESCRIPTION OF DRAWINGS

[FIG. 1] FIG. 1 shows an adhesive film with dicing tape that utilizes and comprises the adhesive agent of the present invention.
[FIG. 2] FIG. 2 is a sectional scheme of an embodiment of the adhesive film with dicing tape that differs from FIG. 1.

### DESCRIPTION OF SOME EMBODIMENTS

In the present invention the term "about" indicates that plus or minus 1 to 10 % of the value following the term "about" is included. For example, "about" 100 °C refers to the range 90 to 110 °C taking into consideration measurement errors etc. Further, value ranges such as "1 to 20" indicates a values of 1 or above to 20 or below.

### (Curable Resin (A))

The curable resin (A) of the present invention comprises a structure in which an alicyclic hydrocarbon with 5 to 8 carbons is substituted by at least four alkyl groups of 4 to 12 carbons. Since such structure contains long arms of long-chain alkyl, it shows excellent stress relaxation effects. Further, because it is formed of alicyclic and aliphatic, it shows excellent moisture resistance.

Note that when the number of carbons in the alkyl group is 4 or more, it is favorable in that excellent stress relaxation property and moisture resistance is obtained. When the number of carbons in the alkyl group is 12 or less, it is favorable in that moisture resistance and adhesiveness become compatible.

Further, the structure may be an alicyclic hydrocarbon with 9 or more hydrocarbon, but since it is difficult to synthesize, it is not practical.

The curable resin (A) comprises a structure containing a cyclohexane-based core and four long arms attached to the core, as described in the following General Formula (1) (hereinafter referred to as "C₃₆" in the present description).

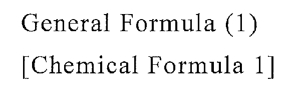

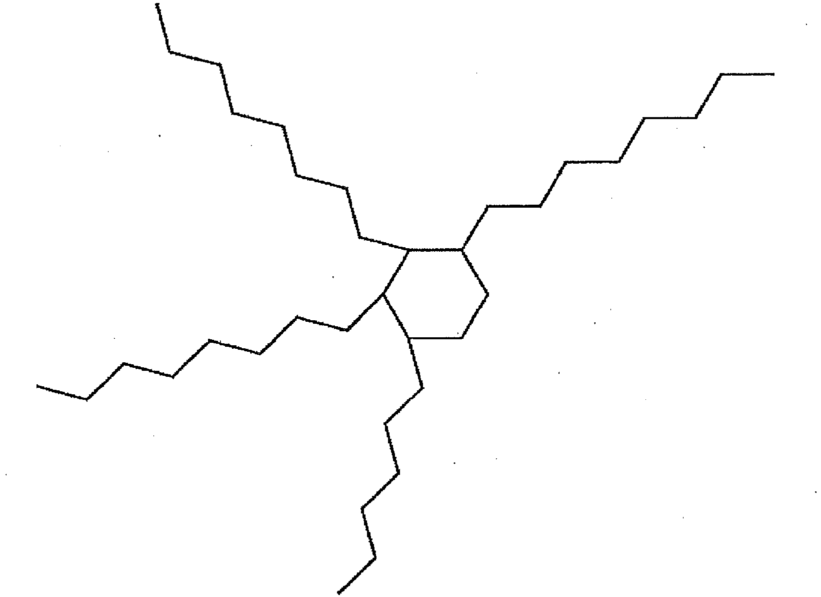

The curable resin (A) of the present invention must further contain at least one curable part.

Here in the present description, a structure that may serve as a "curable part" is, for example, thiol, vinyl ester, acrylate, methacrylate, norbornyl, maleimide, or nadimide may be listed.

Thiol shows excellent adhesion when the adherend and filler are copper. Vinyl ester shows excellent fast-curability and adhesion.

Acrylate and methacrylate are excellent in that they are less susceptible to polymerization inhibition by moisture and base, and do not undergo dark reaction.

Maleimide and nadimide are excellent in that they have low LUMO energy levels and show high reactivity as dienophiles in Diels-Alder reaction.

In the present invention, the structure between the hydrocarbon structure substituted by alkyl groups and the curable part may be any structure. For example, it may be a structure derived from unsubstituted or substituted aliphatic, alicyclic, alkenyl, aryl, heteroaryl, siloxane, poly(butadiene-co-acrylonitrile) and poly(alkylene oxide), an imide structure, or a combinations thereof. Further, it may contain a repeating structure.

Cyclic structures and imide structures are favorable in that they show excellent heat resistance. Aliphatic and alicyclic are favorable in that they show high moisture resistance.

In the present description, "imide" refers to a functional group with two carbonyl groups bonded to a primary amine or ammonia. The general formula for the imide of the present invention is as shown in the following General Formula (2). Note that R, R', R" are arbitrary functional groups.

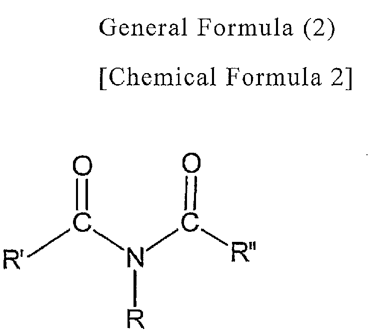

The imide structure incorporated in the compound may be, for example, as follows, but are not limited to these. Note that R is an arbitrary functional group.

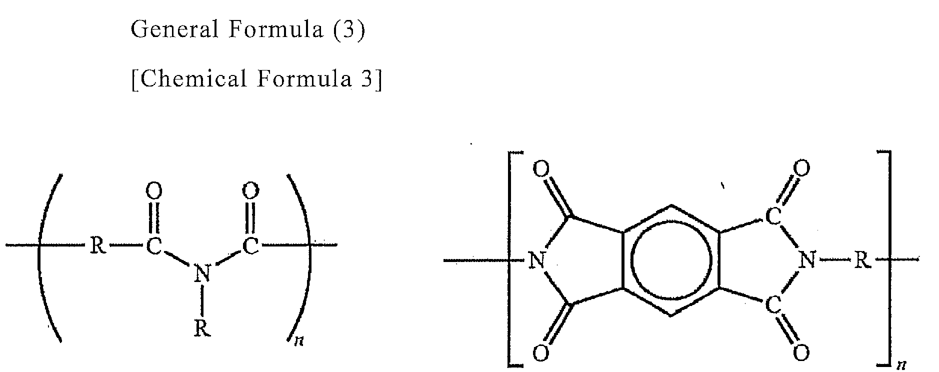

In the present invention, "maleimide" refers to N-substituted maleimide with the structure indicated in the following General Formula (4). Note that R is an aromatic, heteroaromatic, aliphatic, or polymeric part. X₁, X₂ are independently H or alkyl with 1 to 6 carbons.

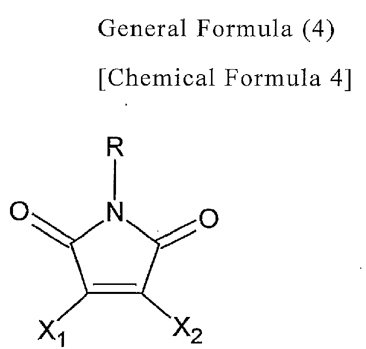

In the present description, "bismaleimide" or "BMI" refers to a polyimide compound to which two maleimide parts are connected. That is, it is the polyimide compound with the general structure shown in the following General Formula (5). Note that R is an aromatic, heteroaromatic, aliphatic, or polymeric part. X₃ to X₆ are independently H or an alkyl with 1 to 6 carbons.

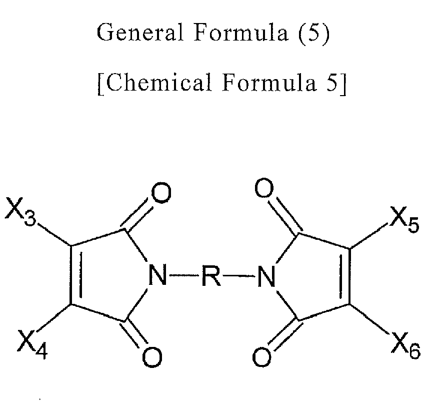

In the present description, "heterocyclic group" refers to a cyclic, in other words, a cyclic-structure-containing group that contains at least one hetero atom (for example, N, O, S etc.) as part of the cyclic structure, with 3 to 14 carbon atoms, and "substituted heterocyclic group" refers to the aforementioned heterocyclic group with one or more substituents.

In the present description, the term "thermosetting" refers to the irreversible property that forms a three-dimensional crosslinked structure between molecules by causing chemical reactions such as epoxy ring-opening and radical polymerization via heat, to thereby obtain larger strength and lower solubility than that prior to setting. Thermosetting resins are resins that show such property and may also set by irradiation (such as visible light, UV light, electron beam irradiation, ion beam irradiation, or x-ray irradiation).

As curable resins related to the present invention, those shown in the following General Formula (6) may be listed.

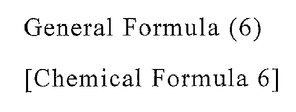

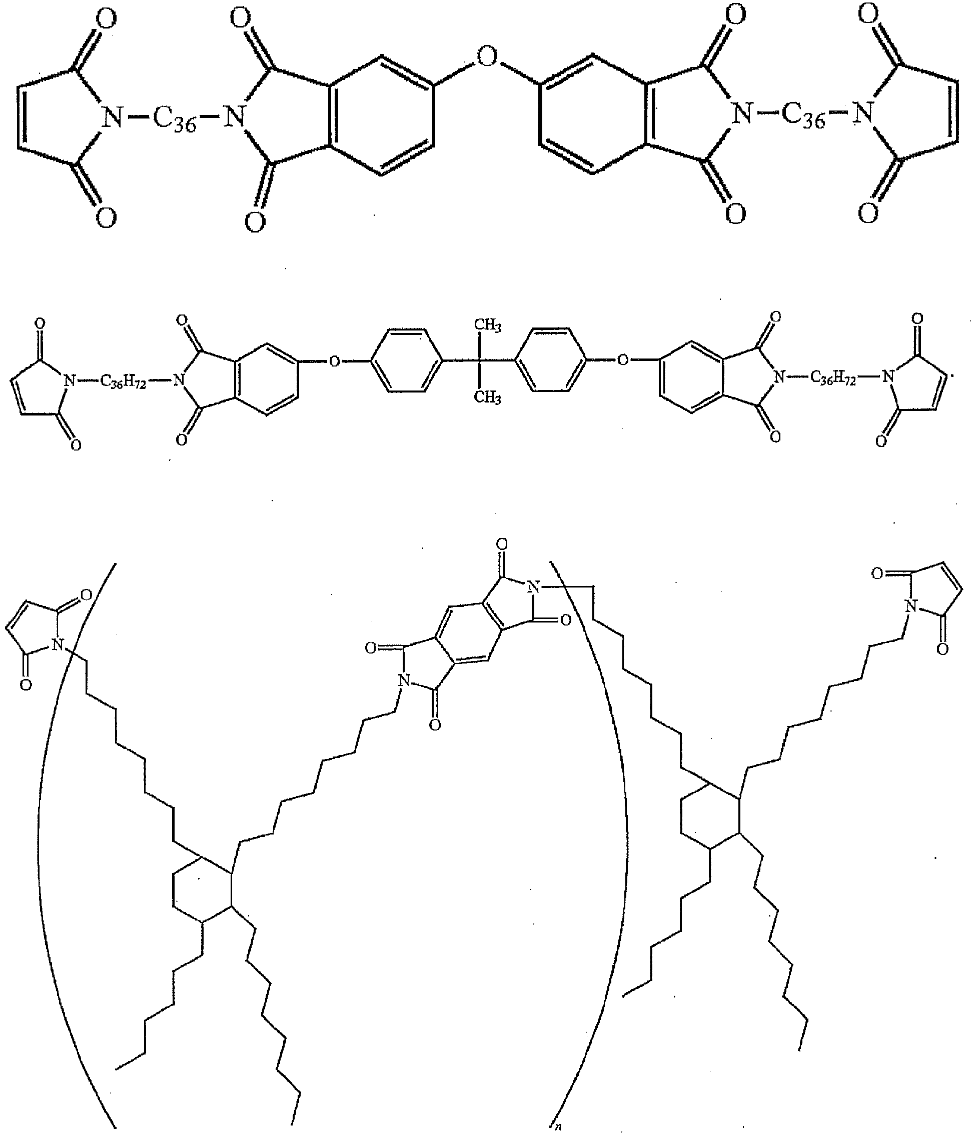

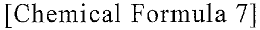

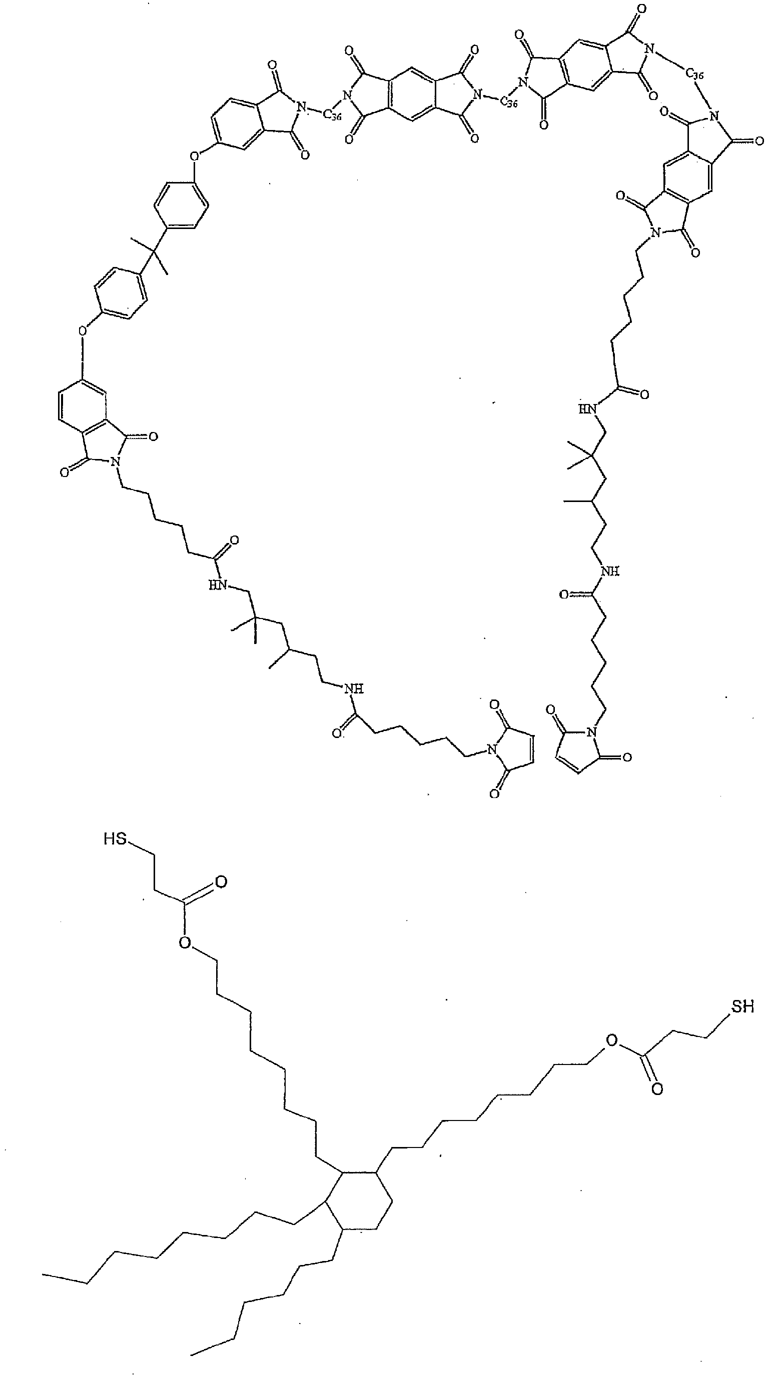

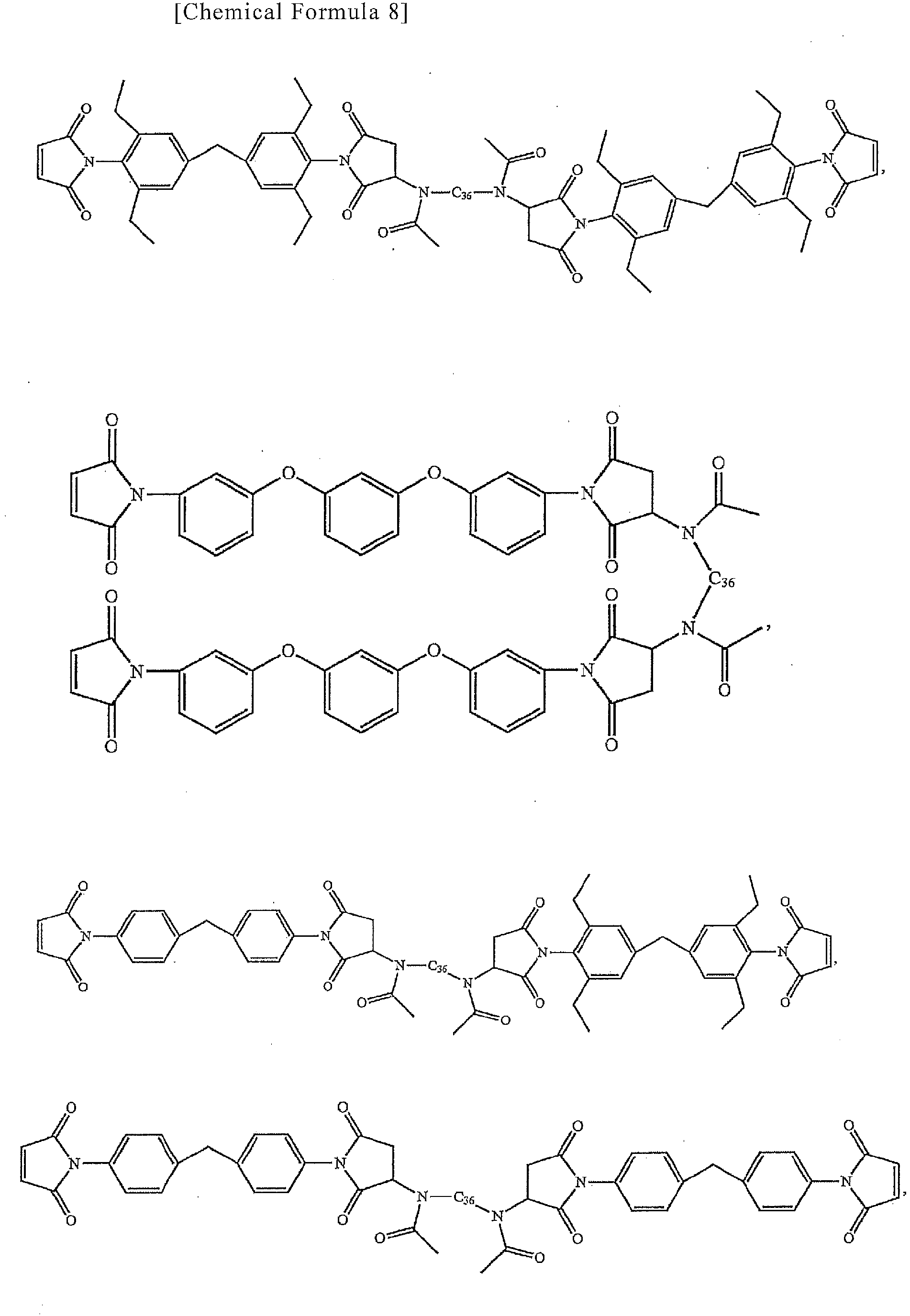

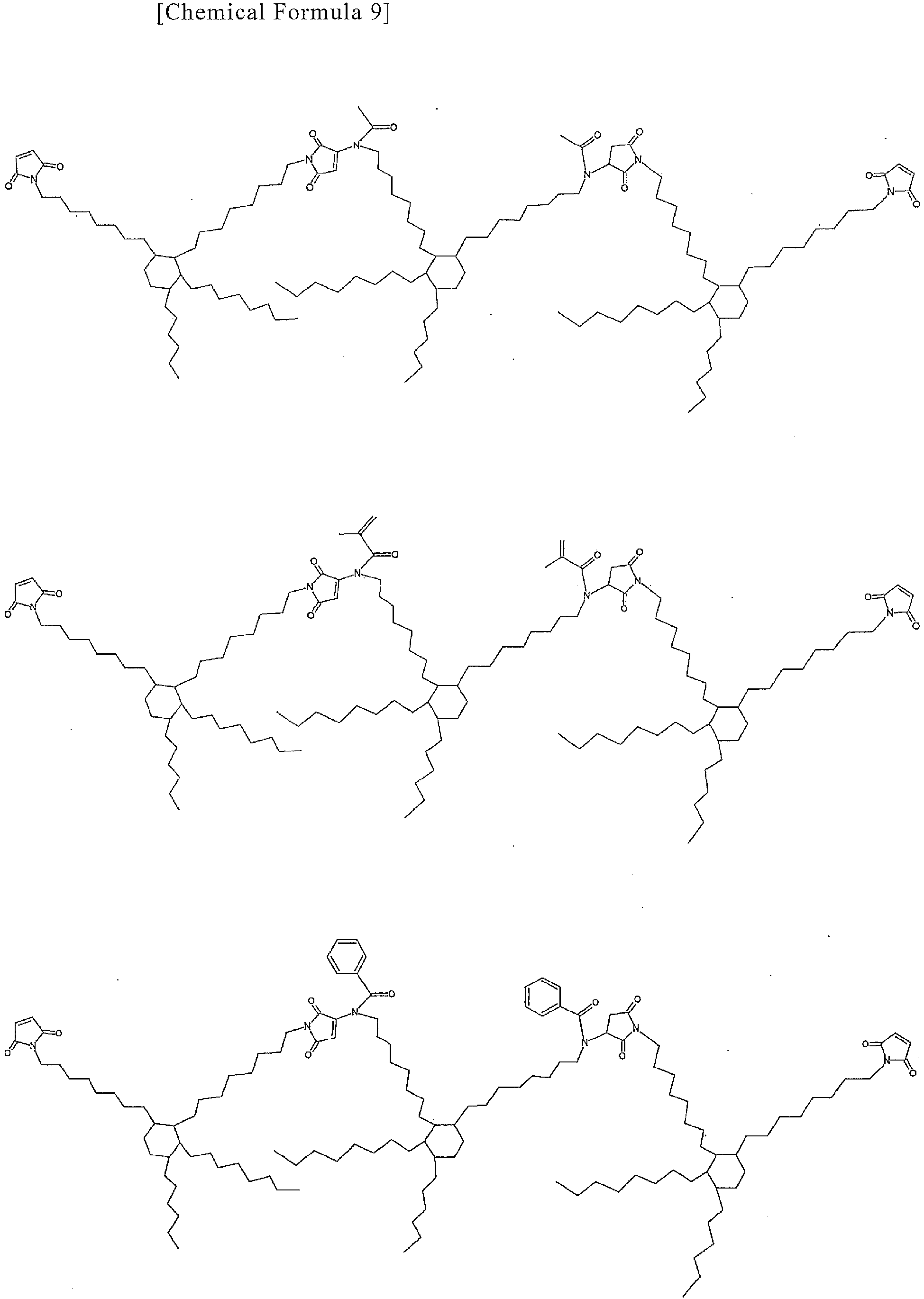

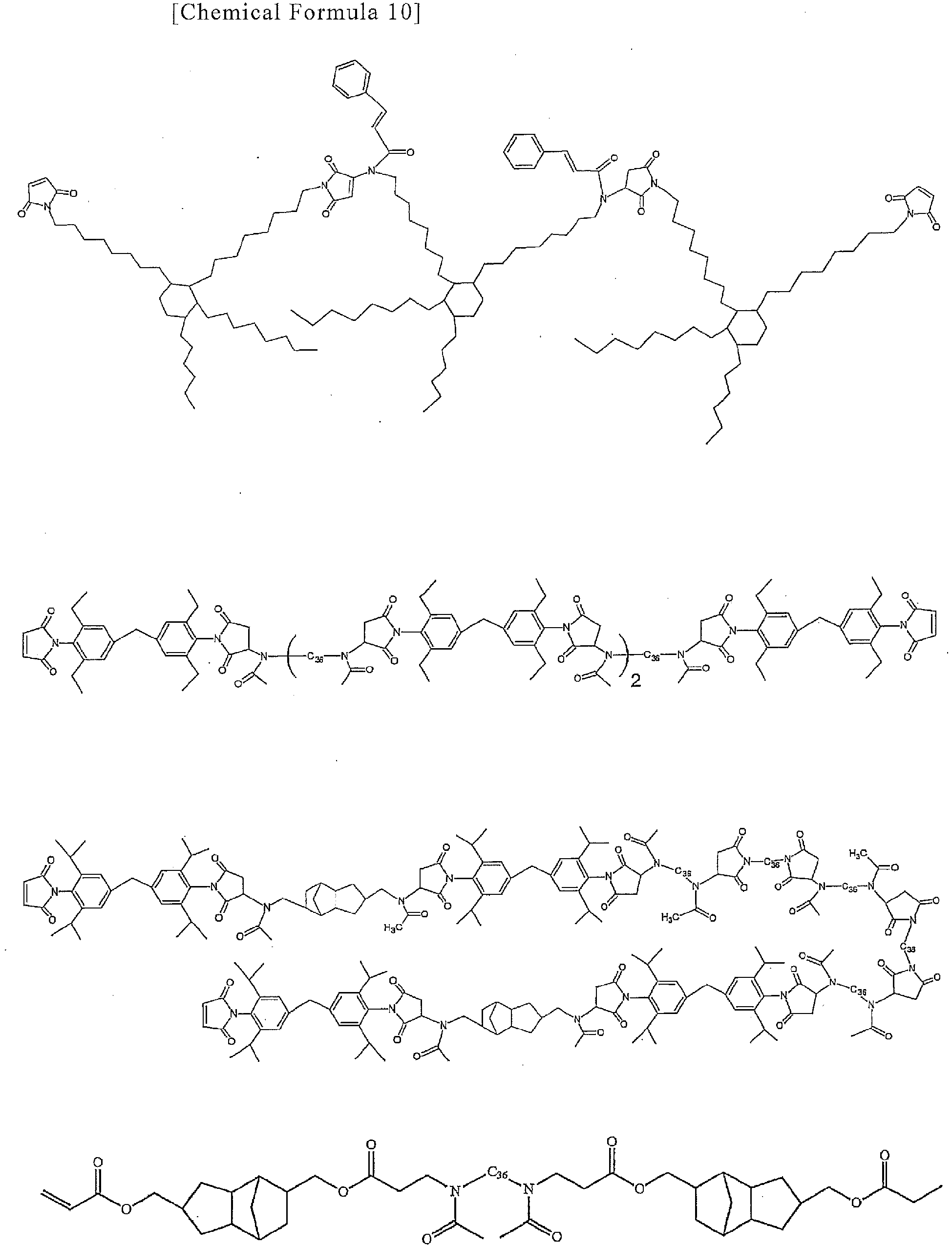

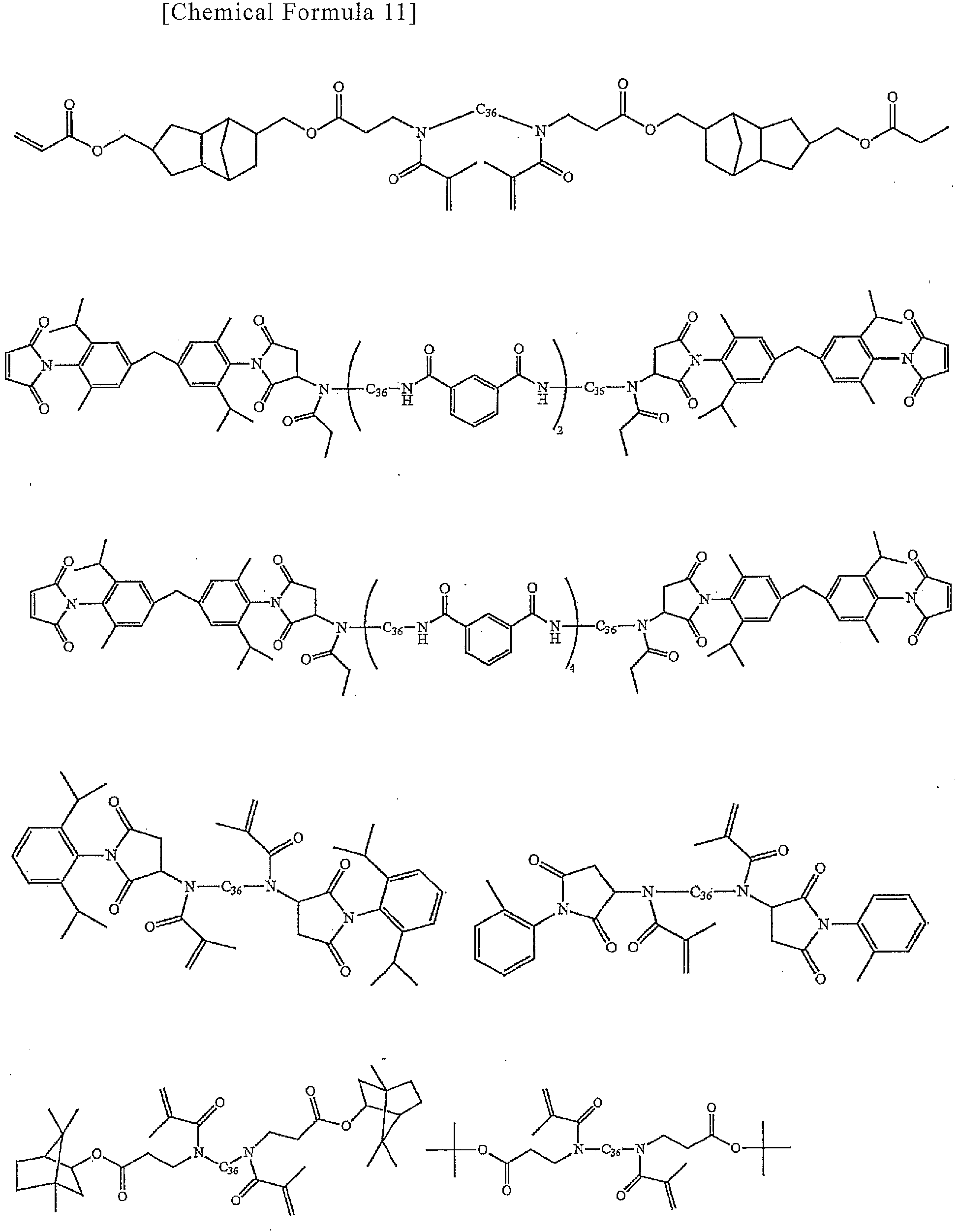

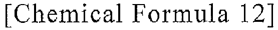

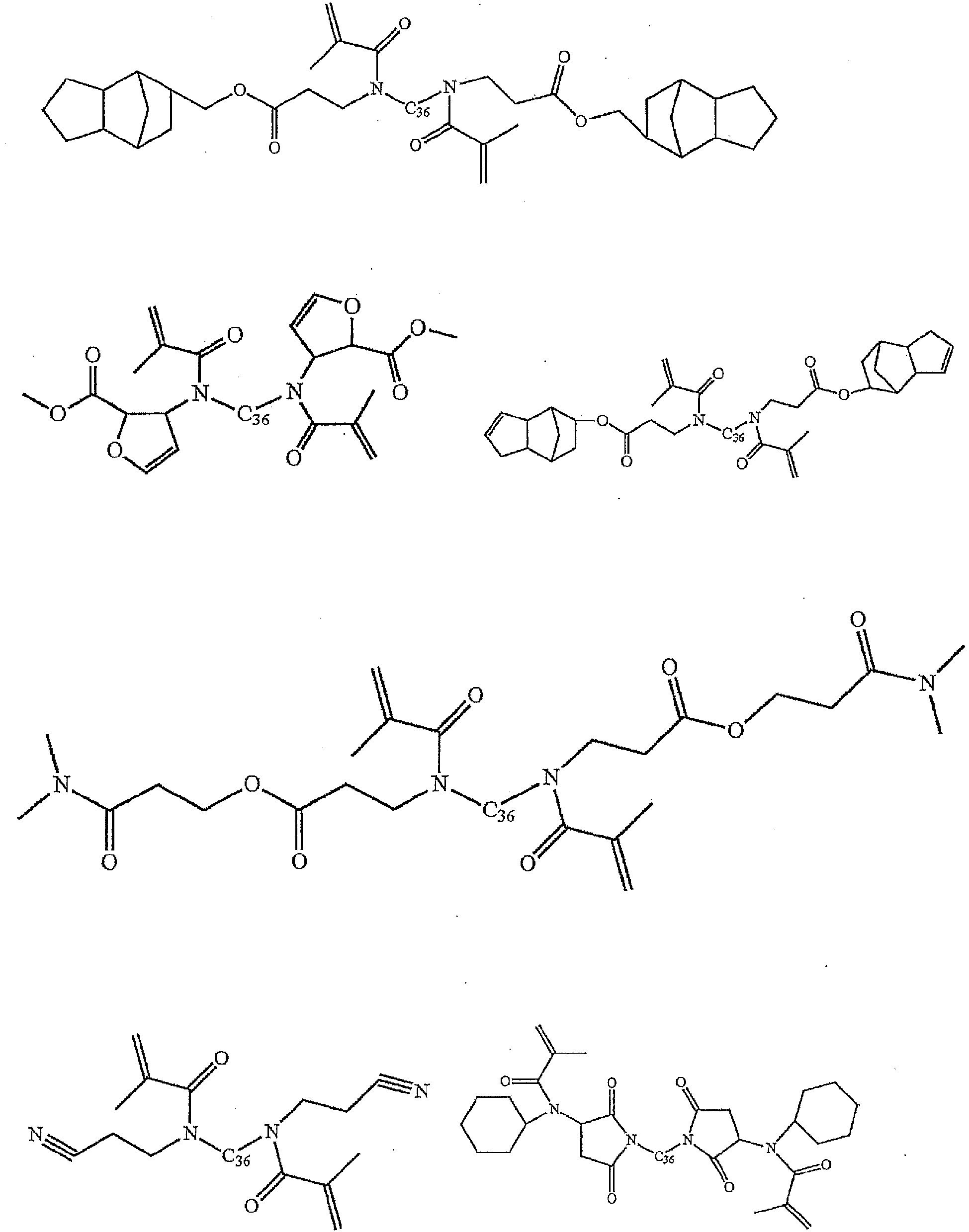

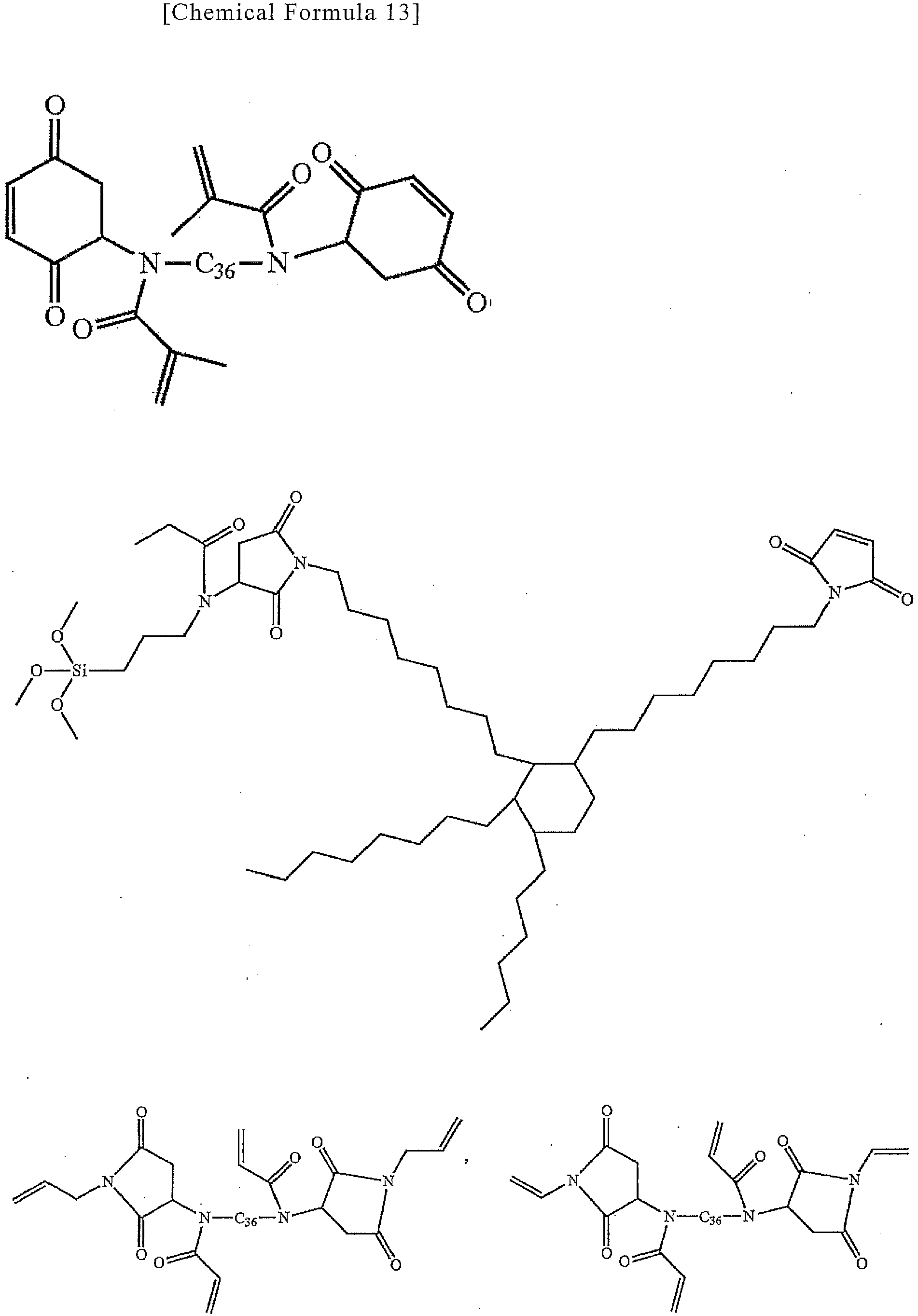

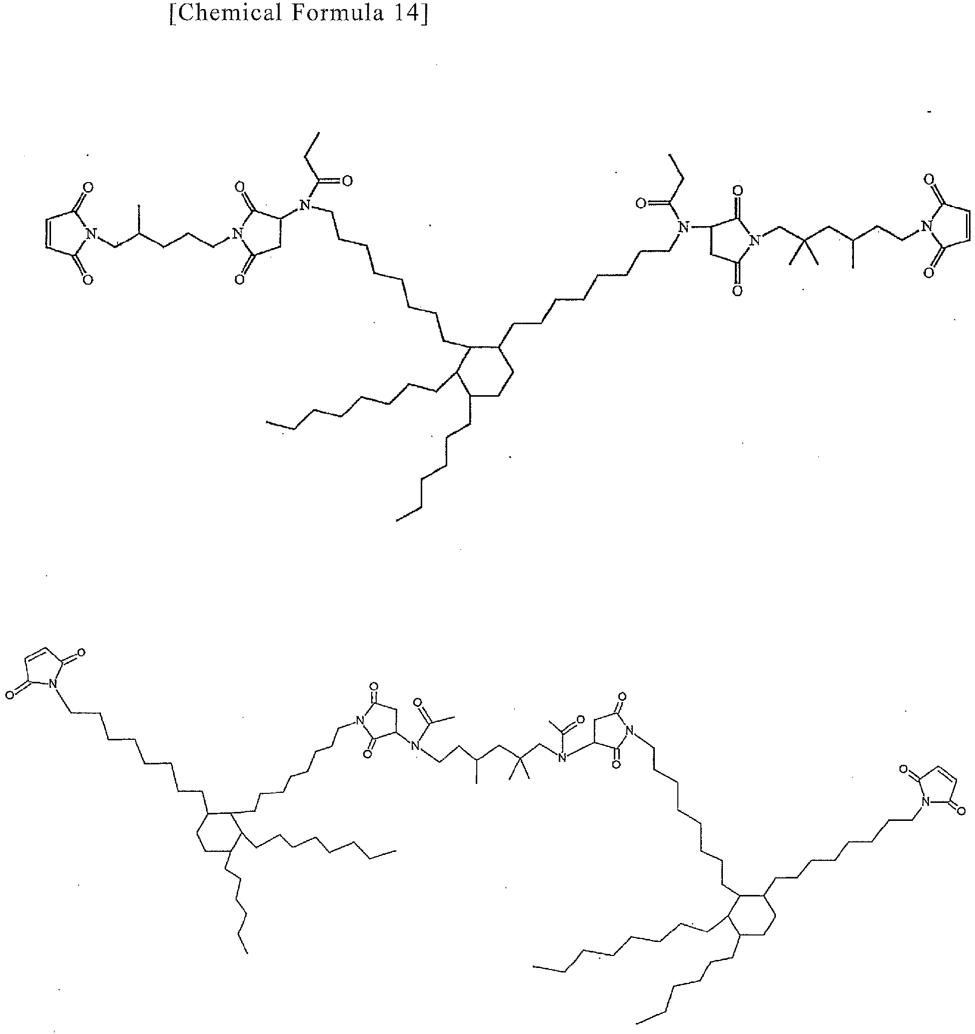

As other structures, for example, maleimide resins described in US 2010/0113643 and US 2013/0299747, with structures containing those defined in the present description, may be listed. However, the structure is not limited to those.

In the present invention, the curable resin may be used in the film independently, or may be used in combination with other adhesive compounds or resins. In one embodiment, the curable resin may be the single thermosetting resin in the adhesive composition. In another embodiment, one or more curable resins may be used in combination or a curable resin and another thermosetting resin may be used together.

In some embodiments, when the mass-average molecular weight of the curable resin is 1,000 or more, film-formation becomes easy, and 2,000 or more is more preferable, and 3,000 or more is further preferable. Further, when the mass-average molecular weight is 30,000 or less, excellent curability is obtained, and 10,000 or less is more preferable and 5,000 or less is further preferable. The mass-average molecular weight can be measured by gel permeation chromatography (GPC) (standard polystyrene conversion).

In some embodiments, the curable resin exist in an amount of 2 to 98 percent by mass in the total mass of the resin component in the film. The amount of curable resin is 50 percent by mass or more in the resin component that composes the film, it is preferably from the view point of stress relaxation and moisture resistance.

### (Polymerization Initiator (B))

As the polymerization initiator (B) in the present invention, radical polymerization initiators etc. may be listed, and the radical polymerization initiator typically exists in the composition at an amount of 0.1 percent by mass to 5 percent by mass of the total amount of resin component in the film. A radical polymerization initiator is a species that functions as a reactive substance at the initiating step of the radical chain reaction, but does not participate in the arbitrary propagating step. In the present description, it refers to an arbitrary chemical species that is not electrically charged when exposed to enough energy (for example, light, heat, or those of similar type), but decomposes into two parts with at least one unpaired electron. As the radical polymerization initiator, for example, azo-compounds, peroxides, hydrocarbon radical polymerization initiators may be listed. Hydrocarbon radical polymerization initiators are disclosed in, for example, JP-A-2009-203384, and is preferable in that the cured resin composition shows excellent electric property.

The radical polymerization initiator that is used in the present invention has a one-hour half-life temperature of 140°C or higher. More preferably, the one-hour half-life temperature is 170°C or higher, and even more preferably, is 200°C or higher. Further, the maximum one-hour half-life temperature of the radical polymerization initiator is not particularly limited, but is preferably 250°C or lower. As such radical polymerization initiators,
3,4-di-t-butyl-2,2,5,5-tetramethylhexane, di-tert-amyl peroxide, di-t-butylperoxide, 3,6,9-triethyl-3,6,9-trimethyl-1,4,7-triperoxonane,
2,5-dimethyl-2,5-di(t-butylperoxy)hexyne-3, p-methane hydroperoxide, isopropylcumyl hydroperoxide, 1,1,3,3-tetramethylbutyl hydroperoxide,
2,4,5,7-tetramethyl-4,5-diphenyloctane, preferably, diisopropylbenzene hydroperoxide, 1,1,3,3-tetramethylbutyl hydroperoxide, tert-amyl hydroperoxide, cumene hydroperoxide, 4,5-dimethyl-4,5-diphenyloctane, t-butyl hydroperoxide, further preferably, 3,4-dimethyl-3,4-diphenylhexane, 2,3-dimethyl-2,3-diphenylbutane may be listed.

### (Polymer Component)

In the present invention, a polymer component may be included to facilitate film formation.

Further, the polymer component may further contribute to stress-relaxation. The polymer component may be any type as long as it is easy to handle and shows compatibility with the curable resin. Examples of favorable resins are thermoplastic resins that are hydrophobic and soluble to toluene. When the polymer component shows compatibility with the curable resin, the thermoplastic resin and the curable resin are most-likely soluble to the same solvent, and as such solvent, an aromatic solvent may be exemplified. Examples of usable solvents are toluene and xylene.

As a thermoplastic resin that is hydrophobic and soluble to toluene, for example, a styrene-butadiene block copolymer, a styrene-isoprene block copolymer, a block copolymer of a mixture of styrene butadiene isoprene, may be listed. The block copolymer of styrene and butadiene that is useful in the present invention may be a di-block copolymer, which contains a styrene polymer segment and a butadiene polymer segment that are covalently bonded to each other. The block copolymer of styrene and butadiene that is useful in the present invention may also be a tri-block copolymer, which contains two segments of styrene polymer and one segment of butadiene polymer, wherein each of the styrene polymer segments are covalently bonded with the butadiene polymer segment.

Another block copolymer of styrene and butadiene that is useful in the present invention may be a block copolymer of styrene and butadiene wherein the butadiene segment is hydrogenated. Further, it may be a tri-block copolymer that contains a styrene polymer segment, a butadiene polymer segment, and a methacrylate ester polymer segment. Other than styrene block copolymers, polyimide precursors such as polyamic acids, polyamic acid esters, and polyamic acid amides, poly-THF, carboxy-terminal butadiene-acrylonitrile rubber, and polypropylene glycol, are favorable. Further, any polymer component of phenoxy, acrylic rubber, polyimide, polyamide, polyacrylate, polyether, polysulfone, polyethylene, polypropylene, polysiloxane, polyvinyl acetate/polyvinyl ester, polyolefin, polycyanoacrylate, which show compatibility with the curable resin, may be suitably used. Furthermore, thermoplastic resins that contain polymer segments equipped with reactive double bonds are capable of reacting with the curable resin during the curing process activated by the radical.

When the mass-average molecular weight of the polymer component is 10,000 or more, excellent film formation easiness is obtained. Further, when the mass-average molecular weight is 1,000,000 or less, excellent moisture resistance, as well as flowability during affixation of the film with the adherend, is obtained. A mass-average molecular weight of 200,000 or less is more preferable, and that of 100,000 or less is further preferable. The mass-average molecular weight can be measured by gel permeation chromatography (GPC) (standard polystyrene conversion). In a specific embodiment, when the compounding ratio of the polymer component is 5 percent by mass or more based on the total mass of the resin component in the film, excellent film formation easiness is obtained. Further, when the compounding ratio of the polymer component is 50 percent by mass or less, excellent moisture resistance, as well as flowability during affixation of the film with the adherend, is obtained. A compounding ratio of 40 percent by mass or less is more preferable, and 30 percent by mass or less is further preferable.

### (Arbitrary Curable Components other than (A))

In the present invention, curable components other than the curable resin may be included. The curable component is not particularly limited. For example, (meth)acrylate compounds having an amide bond in the molecule, acid-modified (meth)acrylate, bisphenol A-type (meth)acrylate, compounds obtained by reacting α, β-unsaturated carboxylic acids to polyhydric alcohols, compounds obtained by reacting α, β-unsaturated carboxylic acids to glycidyl-group-containing compounds, urethane monomers or urethane oligomers such as (meth)acrylate compounds having urethane bonds within the molecule, etc. may be listed. Other than these, nonylphenoxypolyoxy ethylene acrylate, phthalic acid-type compounds such as γ-chloro-β-hydroxypropyl-β'-(meth)acryloyloxyethyl-o-phthalate and β-hydroxyalkyl-β'-(meth)acryloyloxyalkyl-o-phthalate, (meth)acrylic acid alkyl ester, EO-modified nonylphenyl(meth)acrylate, etc., may be exemplified.

In one embodiment, a compound containing isocyanulate ring may be used. In another embodiment, a compound having a tetrahydrofuran structure may be used. These compounds may be used singularly or two or more types may be used in combination. In a specific embodiment, when the compounding ratio of the curable component other than the curable resin is 2 percent by mass or more based on the total mass of the resin component in the film, it is excellent from the view point of flowability during affixation of the film with the adherend and improvement of curability. Further, from the view point of stress relaxation of the film, 30 percent by mass or lower is preferable, and 10 percent by mass or lower is further preferable.

### (Coupling Agent)

In the present invention, a coupling agent may be added. In the present invention, the coupling agent facilitates the bonding between the adhesive film and the adherend. As the coupling agent, one that is compatible with the other components of the present invention may be used. Further, those that participate in radical curing reaction may be used. For example, mercaptosilane-type, acryl-type, γ-mercaptopropyltrimethoxy silane, γ-methacryloxy propyltrimethoxy silane, γ-aminopropyltrimethoxy silane, and vinyltrimethoxy silane may be listed. Silicate esters, metal acrylate salts (for example, aluminum(meth)acrylate), titanate (for example, titanium(meth)acryloxyethylacetoacetate triisopropoxide), or a compound that contains a copolymerizable group and a chilating ligand (for example, phosphine, mercaptan, acetoacetate and others of the same type) may be listed.

In several embodiments, the coupling agent contains both a copolymerizable functional group (for example, vinyl group, acrylate group, methacrylate group, and those of the same type) and a silicate ester functional group. When the adherend or the later-described filler is a metal, the silicate ester part of the coupling agent can undergo condensation with the metal hydroxide on its surface. On the other hand, the copolymerizable functional group can undergo copolymerization with the other reactable components of the adhesive film of the present invention. The coupling agent may be added in the range of 0.1 percent by mass to 5 percent by mass based on the total mass of the resin component in the film.

### (Filler)

The present invention may contain a filler. By adding a filler, functions according to the filler may be added to the adhesive film. On the other hand, when a filler is not added, the film may be superior in terms of stress relaxation and high flowability. The filler may be an organic filler, an inorganic filler, or a metallic filler. Organic fillers are favorable in that they can add toughness to the film, and fillers such as acryl, polyimide, polyamideimide, polyetheretherketone, polyetherimide, polyesterimide, nylon, and silicone may be listed. Inorganic fillers and metallic fillers can improve handling property, improve thermal conductivity, add electric conductivity, control melt viscosity, and improve addition of thixotropic property. The metallic fillers are not particularly limited and may be, for example, gold, silver, copper, aluminum, iron, indium, tin, and alloys thereof. Inorganic fillers are not particularly limited, and may be, for example, aluminum hydroxide, magnesium hydroxide, calcium carbonate, magnesium carbonate, calcium silicate, magnesium silicate, calcium oxide, magnesium oxide, alumina, aluminum nitride, aluminum borate whisker, boron nitride, crystalline silica, and amorphous silica. The form of the filler is not particularly limited. Such fillers may be used singularly or two or more types may be used in combination.

For the purpose of controlling melt viscosity and adding thermal resistance, alumina, silica, aluminum hydroxide etc. are preferable, and silica is more preferable for its versatility. The silica is preferably spherical silica, since it enables the formation of thin adhesive films, and because it enables adding the filler in high ratio.

The specific surface area of the silica filler is preferably 70 to 150 m²/g, and more preferably 100-130 m²/g. When the specific surface area of the silica filler is 70 to 150 m²/g it is advantageous in that a small amount can improve the heat resistance. In another embodiment, the specific surface area of the silica filler is preferably 3 to 12 m²/g, and more preferably 5 to 10 m²/g. When the specific surface area of the silica filler is 3 to 12 m²/g, it is advantageous in improving the heat resistance of the adhesive film because the filler can be added at a high ratio in the adhesive film.

Further, in one embodiment, the average particle size of the silica filler is preferably 0.01 to 0.05 µm, since a small amount can improve the heat resistance, and more preferably 0.012 to 0.03 µm. It is especially preferable that the average particle size is 0.014 to 0.02 µm. In another embodiment, the average particle size of the silica filler is preferably 0.2 to 1 µm, since the filler can be added at a high ratio, and more preferably 0.3 to 0.8 µm. It is especially preferable that the average particle size is 0.4 to 0.6 µm. When adding multiple types of silica filler, it is preferable that the average particle size of at least one type of silica filler is 0.01 to 0.05 µm. Of the remaining types of silica filler, the average particle size of at least one type of silica filler is preferably 0.2 to 1 µm.

The rate of content of the silica filler is preferably 5 to 70 percent by mass based on the total mass of the film, since the heat resistance of the adhesive film can be improved while maintaining flowability at the same time. Further, in relation to the average particle size, for silica filler with an average particle size of 0.01 to 0.05 µm, the rate of content is preferably 5 to 15 percent by mass based on the total mass of the film; for silica filler with an average particle size of 0.2 to 1 µm, the rate of content is preferably 10 to 70 percent by mass based on the total mass of the film, or more preferably 20 to 60 percent by mass based on the total mass of the film; in such cases, the heat resistance of the adhesive film is improved while maintaining flowability at the same time.

In another embodiment, when a filler with a thermal conductivity of 20 W/m.K or more is applied, it is preferable in that the thermal conductivity is improved. It is more preferable that the thermal conductivity is 30 W/m.K or more, and from the view point of securing high thermal conductivity with a small filler content, it is further preferable that the thermal conductivity is 100 W/m.K or more. The thermal conductivity of the filler refers to the value calculated by first, measuring the thermal diffusivity by the laser flash method (for example, measurement condition: laser pulse width of 0.4 ms, laser wave-length 1.06 µm; measurement apparatus: TC7000, product of ULVAC, Inc.), then multiplying the obtained value with the filler's density and specific heat. As such filler, for example, gold (320 W/m.K), silver (420 W/m.K), copper (398 W/m.K), aluminum (236 W/m.K), iron (84 W/m.K), indium (84 W/m.K), tin (64 W/m.K), alumina (Al₂O₃, 30 W/m.K), aluminum nitride (AlN, 260 W/m.K), boron nitride (BN, 275 W/m.K (in-plane direction)), silicon nitride (Si₃N₄, 23 W/m.K) are listed. However, the filler is not limited to these examples. From the view point of having excellent thermal conductivity, metallic fillers or aluminum nitride are preferable, and from the view point of excellent thermal conductivity and electric insulation, aluminum nitride and alumina are preferable. One type may be used singularly or two or more types may be used in combination.

By using a filler with a relatively small average particle size of, for example, 0.1 to 2 µm, or more preferably, 0.2 to 1.8 µm, in combination with a filler with a relatively large average particle size of, for example, 2 to 10 µm, or more preferably, 2.5 to 9.5 µm, the thermal conduction path between the fillers with large average particle size is connected by the fillers with small average particle size. Thus, compared to the case where fillers of the same average particle size is used, high filling becomes possible, which often leads to higher thermal conductivity. In this case, the filler with a small average particle size and the filler with a large average particle size is preferably used in a mass ratio of 1 : 0.1 to 1.0, for the formation of thermal conduction path. In general, when the average particle size is excessively large, the surface profile of the hardened material worsens, and when the average particle size is excessively small, aggregation tends to occur, causing dispersibility to worsen. Thus, for a granular filler, it is preferable to use one with an average particle size of about 0.05 to 10 µm. Further, for an aggregated filler, it is preferable to use one with an average crystal size of 10 to 5000 nm and an average aggregate size of 1 to 1000 µm.

The content of the filler with a thermal conductivity of 20 W/m₊K or more is preferably 30 percent by volume or more of the film, since the thermal conductivity improves, and is more preferably 40 percent by volume or more. Further, the content of the filler with a thermal conductivity of 20 W/m.K or more is preferably 70 percent by volume or less, since excellent film-formation is obtained, and is more preferably 60 percent by volume or less.

Further, in another embodiment, from the view point of improving conductivity, a conductive filler may be added. As such fillers, for example, carbon particles, metallic particles such as silver, copper, nickel, aluminum, gold, tin, zinc, platinum, palladium, iron, tungsten, or molybdenum, alloys thereof, solder particle, particles prepared by subjecting to surface lining or coating with a conductive coating agent such as metal or alloy, may be listed, but are not limited to these. As particles that are coated on the surface with a conductive coating, conductive particles different from the coating agent may be used or, as non-conductive particles, particles comprising, for example, polyethylene, polystyrene, phenol resin, epoxy resin, acrylic resin or benzoguanamine resin, or glass beads, silica, ceramics etc., may be listed. One type may be used singularly or two or more types may be used in combination.

As an alloy, the melting point is preferably 200 °C or lower, since the fillers melt and fuse in the curing process of the adhesive film, leading to higher conductivity. Specifically, Sn42-Bi58 solder (melting point 138 °C), Sn48-In52 solder (melting point 117 °C), Sn42-Bi57-Agl solder (melting point 139 °C), Sn90-Ag2-Cu0.5-Bi7.5 solder (melting point 189 °C), Sn89-Zn11 solder (melting point 190 °C), Sn91-Zn9 solder (melting point 197 °C) etc., are listed. In particular, alloys with melting points of 180 °C or lower are preferable. Further, alloys that contain Sn are preferable in that they are easy to adjust the melting point to 200 °C or lower, and alloys of Sn and Bi are more preferable. Alloys of Sn and Bi with an alloy ratio of Sn:Bi=79:21 to 42:58 are especially preferable, since they show eutectic melting point.

Such conductive filler is preferably one that is capable of forming a sintered compact, since increasing electroconductivity and stronger bonding is enabled. Sintering is a phenomenon wherein particles in a state of contact are maintained at a temperature below its melting point to let the bonding of particles proceed in the direction of decreasing the surface energy of the entire particle system, to thereby densify the particle system. In one embodiment, the (C) filler contains a metal nanofiller, or consists solely of a metal nanofiller, to accelerate sintering. That is, by having fillers of smaller particle size, the total surface area per unit mass increases drastically, causing the contribution of the surface energy to increase. Thus, the amount of thermal energy necessary for melting decreases, allowing sintering at lower temperatures. As such fillers, silver particle, copper particle, or mixtures thereof may be used, and may be prepared by methods described, for example, in JP-A-2005-146408 and JP-A-2012-082516.

In another embodiment, a combination of two or more fillers that undergo transitive liquid phase sintering may be utilized. Liquid phase sintering refers to a special form of sintering in which solid powder particle coexist with the liquid phase. In liquid phase sintering, the metals are diffused within each other to form a new alloy and/or intermetallic body. Thus, the mixture becomes densified and homogenized. In transitive liquid phase sintering, as a result of the homogenization of the metal, the time in which it exists in the liquid phase becomes extremely short. That is, the liquid phase has an extremely high solubility in the surrounding solid phase, and thus, quickly diffuses in the solid, finally leading to solidification. By diffusion homogenizing, heating above the equilibrium melting temperature of the metal particle mixture becomes unnecessary to obtain the final composition.

For example, as the combination that shows superior conductivity, copper-indium-type alloy, copper-tin-type alloy, silver-indium-type alloy, silver-tin-type alloy, gold-indium-type alloy, gold-tin-type alloy, and gold-lead-type alloy may be listed, but the combination is not limited to these examples. All systems including In show an eutectic point around 150 °C, and are superior in that low-temperature sintering proceed smoothly. Further, systems including Sn show an eutectic point around 200 °C, and are preferable from the view point of heat resistance reliability.

Such conductive filler may be spherical, non-spherical, branch-like, flake, plate-like, porous, etc. The average particle size of the filler is preferably 30 µm or smaller, since it becomes easier to make the adhesive film thin and a particle size of 10 µm or smaller is further preferable. When the particle size is 5 µm or smaller, it is preferable, since the surface area increases and the particles become more wettable. At a particle size of 1 µm or less, the total surface area per unit mass increases drastically, causing the contribution of the surface energy to increase. Thus, it is preferable in that the amount of thermal energy necessary for melting decreases and sintering at lower temperatures become possible. Further, the average particle size of a filler is generally 0.005 µm or more. An average particle size of 0.1 µm or more is preferable, since aggregation is less likely to occur, and dispersibility in solvent and resin is enhanced.

Further, in order to increase the contact points between the fillers, the amount of the filler is preferably 75 percent by mass or more of the total mass of the solid content of the conductive adhesive composition, and more preferably, 85 percent by mass or more, and further preferably, 90 percent by mass or more. In order to exert dispersion effects and adhesion-assisting effects by the solvent and resin, the amount of the filler is preferably 99 percent by mass or less, and more preferably, 98 percent by mass or less.

When the filler is conductive, it is preferable that the adhesive film contains a flux. The flux is useful in removing the surface oxide film on the conductive filler. As the flux, any compound may be used without particular limitation, as long as the compound does not hinder the curing reaction of the curable resin and other curable resins. For example, polyhydric alcohols, carboxylic acids, inorganic acids, alkanolamines, phenols, rosins, chloride compounds and their salts, halide compounds and their salts etc. may be listed. As the flux, a single type may be used or two or more types may be used in combination.

In a specific embodiment, the flux is composed of a salt or mixture of carboxylic acid and tertiary amine, and may be of potentiality. In another embodiment, the flux may be inactivated at the completion of the heat treatment of the adhesive film, in which case, it is inactivated by insertion through the reaction between the functional group of the flux and the curable resin.

As the aforementioned polyhydric alcohols, for example, ethylene glycol, diethylene glycol, triethylene glycol, propylene glycol, octene glycol, polyethylene glycol, glycerin, propanediol, and mixtures thereof may be listed. As the aforementioned carboxylic acid, for example, acrylic acid, methacrylic acid, maleic acid, fumaric acid, valeric acid, hexanoic acid, heptanoic acid, 2-ethylhexanoic acid, octanoic acid, 2-methyl heptanoic acid, 4-methyl octanoic acid, nonanoic acid, decanoic acid, neodecanoic acid, dodecanoic acid, tetradecanoic acid, lauric acid, myristic acid, palmitic acid, stearic acid, oleic acid, linoleic acid, linolenic acid, lactic acid, malic acid, citric acid, benzoic acid, phthalic acid, isophthalic acid, oxalic acid, malonic acid, succinic acid, glutaric acid, adipic acid, pyruvic acid, butyric acid, pivalic acid, 2,2-dimethyl butyrate, 3,3-dimethyl butyrate, 2,2-dimethyl valerate, 2,2-diethyl butyrate, 3,3-diethyl butyrate, naphthenic acid, cyclohexanedicarboxylic acid, 2-acryloyloxyethyl succinate, 2-methacryloyloxyethyl succinate, 2-acryloyloxyethyl hexahydro phthalate, 2-methacryloyloxyethyl hexahydro phthalate, 2-acryloyloxyethyl phthalate, 2-methacryloyloxyethyl phthalate, etc. may be listed. In a particular embodiment, the molecular weight of the carboxylic acid is 150 to 300. By having carboxylic acid with a molecular weight of 150 to 300, abnormal increase in viscosity when applying the conductive adhesive composition can be prevented, and the bonding of the conductive particles can be encouraged.

In another embodiment, dicarboxylic acid are preferable. As such dicarboxylic acid, oxalic acid, malonic acid, succinic acid, glutaric acid, fumaric acid, maleic acid etc. may be listed. The tertiary amine is used as a mixture or salt with acidic functional groups, and forms a buffer solution or salt with the acidic functional group of the carboxylic acid, in order to prevent excessively rapid reaction with other organic components. The tertiary amine may be a monomer, oligomer, or polymer combined with one or more compound. As tertiary alkanolamines such as triethanolamine and N,N,N, N,N,N',N'-tetrakis (2-hydroxyethyl) ethylenediamine may be listed, and are suitable in forming buffer mixtures or salts with the carboxylic acidic functional group.

The flux may be introduced to the adhesive film of the present invention in various different forms. For example, in a state of compatibility in the resin, in a state of mixture as a particle, in a state of being coated on the conductive filler, etc., may be listed. The average particle size of the flux in particle form is 30 µm or smaller, and is preferably 15 µm or smaller. By having an average particle size of 15 µm or smaller, the metal becomes easier to melt. It is speculated that by having a smaller average particle size, the apparent melting point of the flux decreases, making it easier to melt, thereby making it easier to remove the oxide film. Further, from the view point of enabling thin film application of the adhesive film, the average particle size is preferably 10 µm or smaller, and more preferably, 6 µm or smaller. From the view point of enhancing printability of the conductive adhesive composition, it is preferably 2 µm or smaller. Further, from the view point of operability, thin film application, and printability, the average particle size is preferably 0.01 µm or larger. Here, the term thin film implies a thickness of 20 µm or thinner. Good applicability refers to a state in which the line width is even when applying the conductive adhesive composition by, for example, a dispenser, to draw a line, and a state in which the surface roughness is within 10% of the film thickness when a film is formed by a coater. Further, printability refers to a state in which the paste viscosity on the target does not increase with time when printed continuously by, for example, screen printing.

Note that the term "average particle size" used in the present specification refers to the D50 value of the cumulative volume distribution curve, in which the 50 volume% particle measured by the laser diffraction method has a smaller diameter than this value. The laser diffraction method is preferably performed using the Malvern Mastersizer 2000 of Malvern Instruments Ltd. In this technology, the size of the particle in a suspension or emulsion is measured by the diffraction of laser beam, based on the application of the Fraunhofer or Mie theory. In the present invention, the Mie theory or the modified Mie theory for non-spherical particle is used, and the average particle size or D50 value is related to the scattering measurement at 0.02 to 135° against the incident laser beam. Further, when it is difficult to measure by the laser diffraction method, the particle size was determined from the diameter of a circle, whose area is about the measured value of the sectional area of the particle from the electron microscope image obtained using a scanning electron microscope (SEM).

As a method of adjusting the average particle size of the flux, a method of pulverizing is exemplified. As a method of pulverization, a grinder may be utilized. As for the types of grinder, those known, such as ball mill grinders, jet mill grinders, ultra fine powder grinders, hammer-type grinders, mortars, roller mills, etc., may be listed. Note that the method of adjusting average particle size is not limited to these examples.

When the amount of the flux is 0.5 parts by mass or more, based on the total 100 parts by mass of the conductive filler in the film, it is preferable, since the metal is easily melted; 0.8 parts by mass or more is more preferable, and 1.0 parts by mass or more is even more preferable. Further, when the amount of the flux is 20 parts by mass or less, based on the total 100 parts by mass of the conductive filler in the film, it is preferable, since the moisture resistance of the adhesive film is maintained; 15 parts by mass or less is more preferable, and 10 parts by mass is even more preferable.

### (Other Arbitrary Components)

In another embodiment, the conductive adhesive composition of the present invention may further include one or more additive such as a plasticizer, an oil, a stabilizer, an antioxidant, a corrosion preventative, an inhibitor, a chelating agent, a pigment, a dye, a polymer additive, a defoaming agent, a preservative, a thickener, a rheology-adjusting agent, a moisturizing agent, a tackifier, a dispersant, and water.

### (Production of Adhesive Film)

The adhesive film may be produced by ordinary methods. For example, after preparing a varnish containing the curable resin, the varnish may be applied on a cover film at a certain thickness to form a coated membrane; by drying the coated membrane under a certain condition, the adhesive film may be produced. The method of application is not particularly limited, and for example, roll coating, screen coating, and gravure coating etc. may be listed. Further, as the drying condition, for example, drying may be performed at a temperature of 80 to 130°C for a time range of 1 to 5 minutes. As the cover film, polyethylene-terephthalate (PET), polyethylene, polypropylene, or plastic films and paper coated with a peeling agent such as fluorine-type peeling agents, long-chain alkylacrylate-type peeling agents etc. may be used. It is preferable to form a film using such methods, since the thickness between the adherends may be maintained and handling becomes easy. To form a film with the conductive adhesive composition, it is preferable that a curable resin with a mass average molecular weight of 1000 or more is applied, or that the composition contains a polymer component.

The thickness of the adhesive film is not particularly limited, but may preferably be 1 to 300 µm. When adhering two layers of adherends, the thickness is preferably 5 to 60 µm, and when stress-relaxation is required, the thickness is preferably 60 to 200 µm.

Further, by combining the adhesive film with a dicing tape in the form of a laminate, the adhesive film may be used favorably as an adhesive film with dicing tape. A dicing tape is a tape that is used mainly in the process of cutting wafer using a dicing saw to thereby divide integrated circuits and packages formed on a semiconductor wafer.

Since the adhesive film is radically curable, it may be used in combination with a dicing tape that has a radiation curable adhesive layer that is irradiated beforehand, or a pressure-sensitive adhesive layer, on the part of the wafer that is to be adhered.

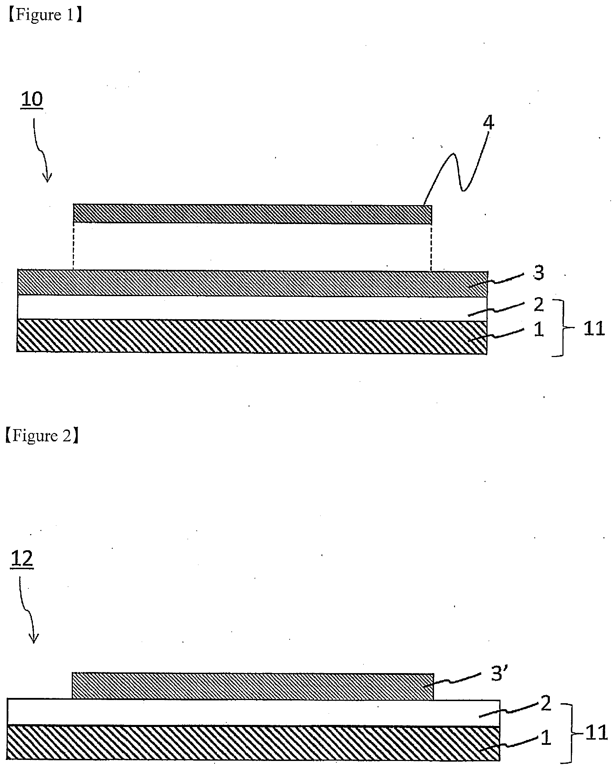

FIG 1 and FIG 2 are schematic diagrams that show the sectional views of one embodiment of the adhesive film with dicing tape of the present invention.

In FIG 1, the structure of the adhesive film with dicing tape 10, in which the adhesive film 3 is laminated on the dicing tape 11, is shown. The dicing tape 11 is composed of a pressure-sensitive adhesive layer 2 laminated on a substrate 1, and the adhesive film 3 is provided on top of the adhesive layer 2. As shown in the adhesive film with dicing tape 12 of FIG 2, the adhesive film 3' may be formed only on the work-sticking part.

The substrate 1 is the strength matrix of the adhesive film with dicing tape 10, 12 and preferably shows ultraviolet transmission property and expandability when expanded. For example, polyolefins such as polyethylene, polypropylene, polybutene, and polymethylpentene, ethylene-vinyl acetate copolymer, ionomer resin, ethylene-(meth)acrylic acid copolymer, ethylene-(meth)acrylic acid ester (random, alternating) copolymer, ethylene-butene copolymer, ethylene-hexene copolymer, polyurethane, polyesters such as polyethylene terephthalate and polyethylene naphthalate" polycarbonate, polyimide, polyether ether ketone, polyether imide, wholly aromatic polyamide, polyphenylsulfide, aramid (paper), glass, glass cloth, fluorine resin, polyvinylchloride, polyvinylidenechloride, cellulose-type resin, silicone resin, crosslinked bodies of the aforementioned resins, metal (foil), paper etc. can be listed.

In order to enhance adhesion, retention, etc., the surface of the substrate 1 may be subjected to conventional surface treatments such as various chemical and physical treatments like chromic acid treatment, ozone exposure, flame exposure, high voltage lightening exposure, ionizing radiation treatment, coating treatment using primers (such as the later-described adhesive substance).

As the substrate, the same or different materials may be arbitrarily selected and used, and several types may be blended and used as necessary. Further, different types may be layered and used.

The thickness of substrate 1 is not particularly limited, but may generally be about 50 to 200 µm.

The adhesive material to be used in the pressure-sensitive adhesive layer 2 is not particularly limited, and general pressure-sensitive adhesive such as acrylic-type adhesive and rubber-type adhesive.

As the adhesive material used to form the pressure-sensitive adhesive layer 2, radiation-curable resins may also be used. The adhesive strength of radiation-curable resins may easily be reduced by irradiation of radiation such as ultraviolet ray to increase the degree of crosslinking.

As the radiation-curable adhesive agent, those having radiation curable functional groups such as carbon-carbon double bonds that also show adhesiveness may be used without particular limitation. For example, addition-type radiation-curable adhesive agents obtained by combining radiation-curable monomer components and oligomer components to general pressure-sensitive adhesive agents such as the aforementioned acrylic-type adhesive agent and rubber-type adhesive agent may be exemplified.

As the radiation-curable monomer component to be combined, for example, urethane oligomer, urethane(meth)acrylate, trimethylol propane tri(meth)acrylate, tetramethylol methane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butanediol di(meth)acrylate etc. may be listed. Further, as the radiation-curable oligomer component, various oligomers such as urethane-type, polyether-type, polyester-type, polycarbonate-type, polybutadiene-type may be listed, and those with a molecular weight in the range of 100 to 30000 are suitable. The amount of radiation-curable monomer components and oligomer components may be determined arbitrarily according to the type of the adhesive layer. In general, the amount is, for example, 5 to 500 parts by mass, or more preferably, 40 to 150 parts by mass, based on 100 parts by mass of the base polymer such as the acrylic polymer composing the adhesive layer.

Further, as the radiation-curable adhesive agent, other than the aforementioned addition-type radiation-curable adhesive agent, endogenous-type radiation-curable adhesive agents that have carbon-carbon double bonds on the polymer side chain, main chain, or end of the main chain may be listed as the base polymer. Such endogenous-type radiation-curable adhesive agents do not require the addition of oligomer components etc., or do not contain many, and are thus preferable, since chronological migration of the oligomer components within the adhesive agent, or migration to the adhesive film 3 does not occur.

Further, as the radiation-curable adhesive agent, for example, an addition polymerizable compound having two or more unsaturated bonds as disclosed in JP-A-S60-196956, rubber-type adhesive agents and acrylic-type adhesive agents containing a photo-polymerizable compound that has an epoxy group such as alkoxysilane and a photopolymerization initiator such as carbonyl compounds, organic sulfur compounds, peroxides, amines, onium salt-type compounds may be listed.

The thickness of the pressure-sensitive adhesive layer 2 is not particularly limited, but is preferably about 1 to 50 µm. Preferably, the thickness is 2 to 30 µm, or further preferably, 5 to 25 µm.

FIG 1 shows a concise example of the structure and method for producing a semiconductor device using such an adhesive film with dicing tape.

More specifically, on the semiconductor wafer sticking part of the adhesive film 3 of the adhesive film with dicing film 10, a semiconductor wafer 4 is pressure bonded, and fixed by adhesion holding (adhesion process). This process is performed by a pressurizing means such as a pressurizing roll.

### EXAMPLE

Hereinafter, the present invention will be described more specifically with reference to the following Examples. However, the present invention is not limited in anyway by these Examples.

A varnish obtained by blending the components shown in Table 1 and a suitable amount of toluene was applied on a cover tape comprising a PET film of 50 µm thickness, and passed through a drying furnace at 140 °C for 5 minutes, to form adhesive films each with a thickness of 30 µm, after which they were affixed with a dicing tape to form rolls of the adhesive films of Examples 1 to 10 and Comparative Examples 1 and 2, as adhesive films with dicing tape. The acrylic-type UV dicing tape of which adhesive strength (to #280SUS) of only work-sticking part had been adjusted to 0.5N/25mm or lower beforehand by irradiation of radiation was used.

**[Table 1]**

| | Example 1 | | Example 2 | | Example 3 | | Example 4 | | Example 5 | | Example 6 | |
|---|---|---|---|---|---|---|---|---|---|---|---|---|
| Curable Resin | Curable Resin 1 | 8 % | Curable Resin 2 | 8 % | Curable Resin 3 | 8 % | Curable Resin 4 | 9.5 % | Curable Resin 3 | a % | Curable Resin 3 | 8 % |
| Other Curable Resin | | | | | | | | | | | | |
| Initiator | Nofmer BC | 0.4 % | Nofmer BC | 0.4 % | Nofmer BC | 0.4 % | Nofmer BC | 0.5 % | TRIGONOX 30 | 0.4 % | Luperox TAH | 0.4 % |
| Polymer | | | | | | | | | | | | |
| Filler | Sn72-BI28 | 37 % | Sn72-Bi28 | 37 % | Sn72-BI28 | 37 % | EA0297 | 90 % | Sn72-Bi28 | 90 % | Sn72-Bi28 | 90 % |
| | Cu Filler | 53 % | Cu Filler | 53 % | Cu Filler | 53 % | | | | | | |
| Others | Tetra EG | 1.6 % | Tetra EG | 1.6 % | Tetra EG | 1.6 % | | | BHPA | 1.6 % | Tetra EG | 1.6 % |
| Film Property | A | | A | | A | | A | | A | | A | |
| Room Temperature Stability After 3 days | A | | A | | A | | A | | B | | A | |
| Room Temperature Stability After 7 days | A | | A | | A | | A | | B | | B | |
| Stress Relaxation | A | | A | | A | | A | | A | | A | |
| Moisture Resistance | A | | A | | A | | A | | A | | A | |
| | | | | | | | | | | | | |

| | Example 7 | | Example 8 | | Example 9 - | | Example 10 | | Comparative Example 1 | | Comparative Example 2 | |
|---|---|---|---|---|---|---|---|---|---|---|---|---|
| Curable Resin | Curable Resin 3 | 21 % | Curable Resin 3 | 33.2 % | Curable Resin 3 | 28.3 % | Curable Resin 3 | 26.4 % | YL980 | 23.3 % | Curable Resin 3 | 8 % |
| Other Curable Resin | | | | | | | EBECRYL170 | 2 % | | | | |
| Initiator | NofmerBC | 1.1 % | NofmerBC | 1.8 % | NofmerBC | 1.4 % | Initiator A | 1.3 % | | | Percumyi D | 0.4 % |
| Polymer | FG1901 | 13.7 % | | | | | FG1901 | 45 % | PKHA | 16 % | | |
| Filler | Sn72-Bi28 | 60 % | AlN | 65 % | SO-C2 | 70 % | SO-C2 | 25 % | SO-C2 | 60 % | Sn72-Bi28 | 37 % |
| | | | | | | | | | | - | Cu Filler | 53 % |
| Others | BHPA | 4.2 % | | | Z-6030 | 0.3 % | Z-6030 | 0.3 % | 2PHZ-PW | 0.7 % | BHPA | 1.6 % |
| Film Property | B | | A | | A | | B | | B | | C | |
| Room Temperature Stability After 3 days | B | | A | | A | | B | | - | | - | |
| Room temperature Stability After 7 days | B | | A | | A | | B | | - | | - | |
| Stress Relaxation | A | | A | | A | | A | | B | | Untestable | |
| Moisture Resistance | B | | C | | A | | C | | B | | Untestable | |

### <Adhesive Film Property Evaluation>

The adhesive films of Examples 1 to 10 and Comparative Examples 1 and 2 were fixed on to a silicon wafer of 50 µm thickness and 200 mm diameter at a heating temperature of 90 °C or 110 °C, at an affixation speed of 12 mm/s. This affixation process was performed for 10 silicon wafers. The adhesive films were evaluated by checking whether or not they were affixed properly without void, and functional as adhesive films. The evaluation results are shown in Table 1.
A: all ten films could be affixed at 90 °C.
B: all ten films could be affixed at 90 °C or 110 °C.
C: at least one film showed affixation defects.

### <Room Temperature Stability>

The adhesive films of the Examples that showed adhesive film properties of A or B were preserved in a clean room, and subjected to the same affixation experiment as with the Adhesive Film Property Evaluation after 24 hours and 3 days. The results are shown in Table 1.
A: all ten films could be affixed at 90 °C.
B: all ten films could be affixed at 90 °C or 110 °C.
C: at least one film showed affixation defects.

### <Preparation of Semiconductor Device>

The adhesive films of Examples 1 to 10 and Comparative Example 1 were fixed on to the Ag-metalized side of a silicon wafer of 50 µm thickness and 20 mm diameter at a heating temperature of 90 °C and an affixation speed of 12 mm/s. Then, using a dicer, the semiconductor wafer and the adhesive film were diced to a size of 5 mm x 5 mm, after which the adhesive film and the dicing tape were separated to obtain a semiconductor chip with adhesive film. Each semiconductor chip with adhesive film obtained were heat crimped on to a lead frame with a Ag-metalized side of 180 µm thickness via the adhesive film at a temperature of 150 °C, while adding a force of 0.4 MPa for 1 second. Subsequently, the adhesive film was cured by heating at a temperature of 230 °C for 1 hour while adding a force of 0.5 MPa. Next, using an epoxy sealing resin (product name: CEL-9700HF, product of Hitachi Chemical Co., Ltd.), resin sealing was performed under a condition of 180 °C, 6.75 MPa, 90 seconds, to produce 40 samples of semiconductor devices.

### <Stress Relaxation Test>

Twenty samples each of the semiconductor device obtained using the adhesive films of the Examples and Comparative Examples were subjected to a heat cycle test. 100 cycles were repeated with each cycle consisting of exposure to -55 °C for 30 minutes and 150 °C for 30 minutes. The tested semiconductor devices were evaluated for the presence of peeling at the interface between the upper surface of the chip and the sealing resin, using an ultrasonic probe imaging device.
A: No peeling was detected for all 20 semiconductor devices.
B: Peeling was detected in at least one semiconductor device.

### <Moisture Resistance Test>

Twenty samples each of the semiconductor device obtained using the adhesive films of the Examples and Comparative Examples were subjected to moisture absorption by putting in a temperature and humidity testing chamber at 85 °C/60 %RH for 168 hours. Ten samples each were taken and the interface between the adhesive film and the lead frame was observed using an ultrasonic probe imaging device. The remaining 10 samples were passed through a reflow furnace with a maximum temperature of 260 °C three times, after which the interface between the adhesive film and the lead frame was observed similarly using an ultrasonic probe imaging device.
- : Peeling was observed in the sample immediately after moisture absorption and could not be subjected to moisture resistance test.
   A: No peeling was detected in all 10 samples of the semiconductor device after reflow.
   B: Peeling was detected in 1 or 2 semiconductor devices.
   C: Peeling was detected in 3 or more to 5 or less semiconductor devices.
   D: Peeling was detected in 6 or more semiconductor devices.

Note that details of each components were as follows:
Curable Resin 1: That obtained by polymerization of the following compound. 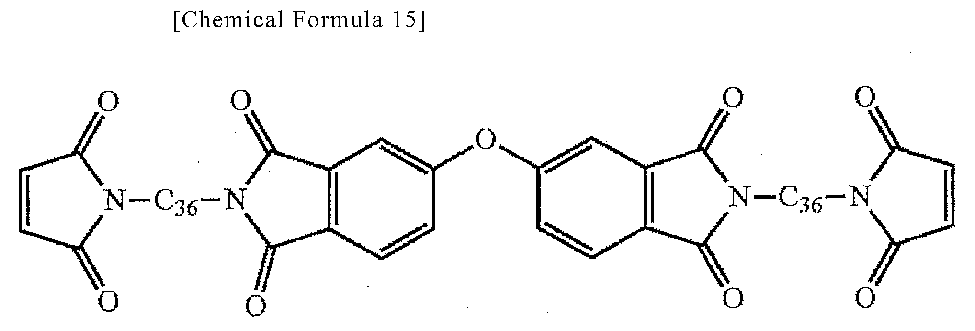
Curable Resin 2: That obtained by polymerization of the following compound. 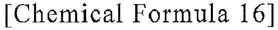 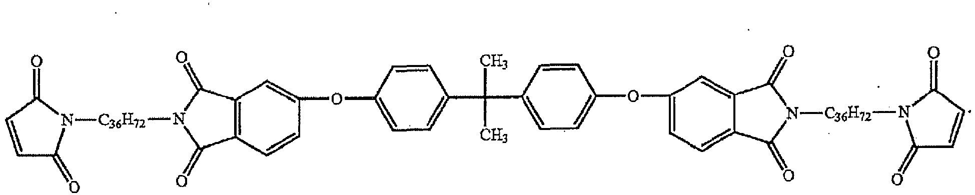
Curable Resin 3: The following polymer (n=1 to30). 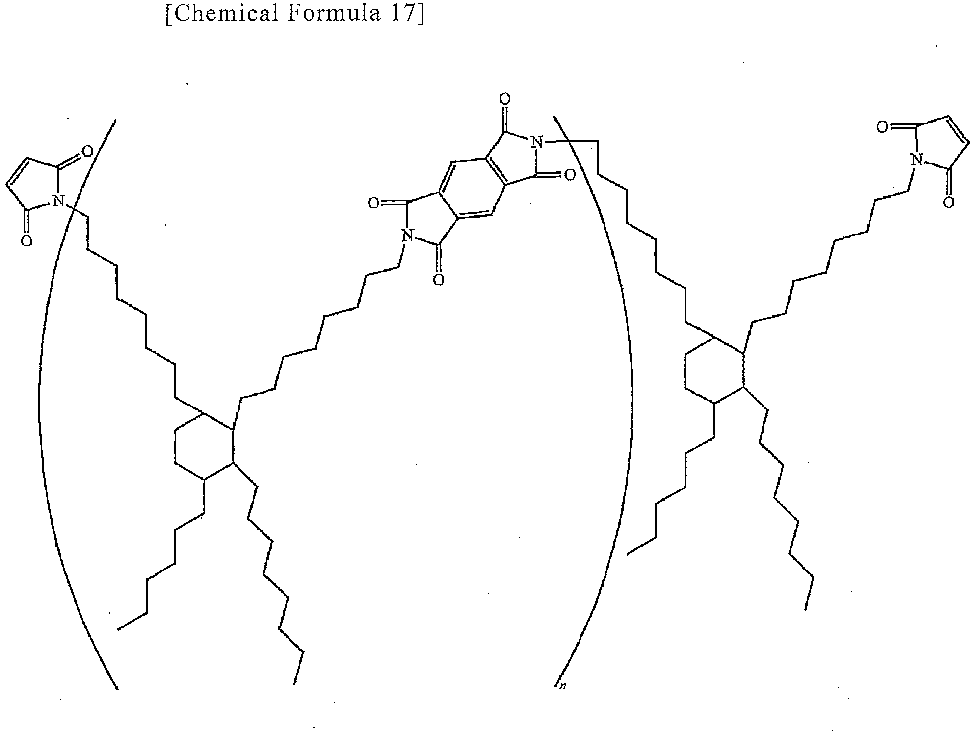
Curable Resin 4: The following polymer (n=1 o 30).

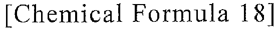

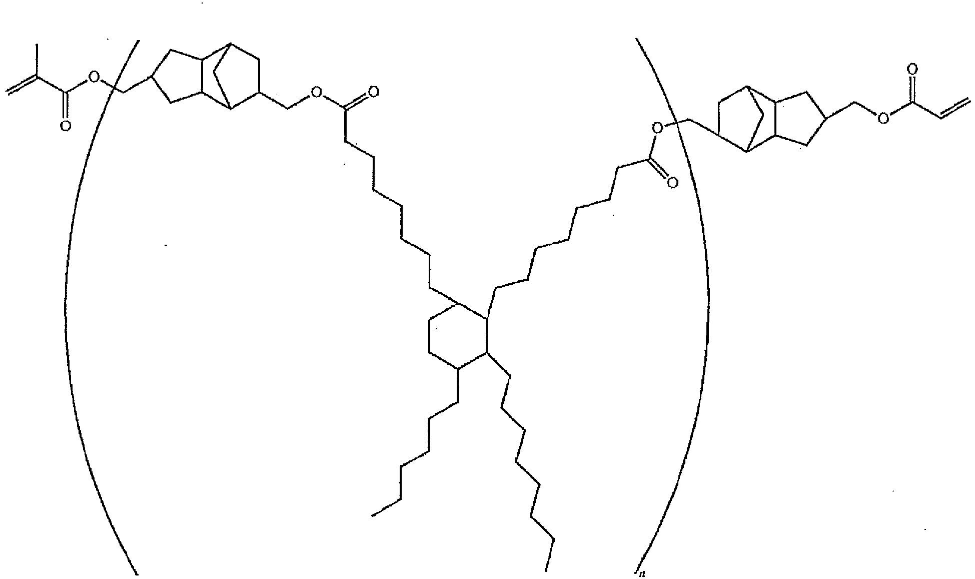

EBECRYL170: phosphoric acid acrylate, product of Allnex
FG1901: KRATON (registered trade mark) FG1901G, SEBS grafted with MA
SO-C2: silica filler, product of Admatechs, average particle size 0.5 µm
AlN: aluminum nitride H grade, product of Tokuyama Corporation, average particle size 1.1 µm, Mohs' hardness 8, thermal conductivity 200 W/m.K
Cu Filler: spherical copper powder, average particle size 3 µm, surface treatment by stearic acid
Sn72-Bi28: spherical solder, melting point 139 °C, average particle size 3 µm
EA0297: silver flake, average particle size 4 µm, product of Metalor
BHPA: flux, 2,2-bis(hydroxymethyl)propionic acid (product of Tokyo Chemical Industry Co., Ltd.) subjected to pulverization treatment by a jet mill pulverizer (product of Nisshin Engineering Inc., current jet), average particle size 10 µm
Tetra EG: flux, tetraethylene glycol, liquid, boiling point 328 °C
Z-6030: silane coupling agent, 3-methacryloyloxypropyl triethoxy silane, product of Toray Dow Corning Silicone Corporation
TRIGONOX 301: 3,6,9-triethyl-3,6,9-trimethyl-1,4,7-triperoxonane, one-hour half-life temperature 146 °C, product of Akzo Nobel
Luperox TAH: tert-amyl hydroperoxide, one-hour half-life temperature 183 °C, product of Arkema Inc.
Nofmer BC: 2,3-dimethyl-2,3-diphenylbutane, one-hour half-life temperature 234 °C, product of NOF corporation
Initiator A: 3,4-dimethyl-3,4-diphenylhexane, one-hour half-life temperature 211 °C
Percumyl D: dicumyl peroxide, one-hour half-life temperature 136 °C, product of NOF Corporation
YL980: bisphenol A-type epoxy resin, hydrolyzable chlorine concentration 150 ppm, product of Mitsubishi Chemical Corporation
PKHA: phenoxy resin, molecular weight 25,000, product of InChem Industry
2PHZ-PW: epoxy resin curing agent, 2-phenyl 4,5-dihydroxymethyl imidazole, decomposition temperature 230 °C, product of Shikoku Chemicals Corporation

In Examples 1 to 9, since the one-hour half-life temperature of the polymerization initiator was 140 °C or higher, the curing reaction did not proceed during the film-formation process, and thus, the films were suitable as adhesive films, and could be affixed at low temperatures of 100 °C or lower.

In Example 10, since the one-hour half-life temperature of the polymerization initiator was 140 °C or higher, the curing reaction did not proceed during the film-formation process, and the film was suitable as an adhesive film.

In Comparative Example 2, since the one-hour half-life temperature of the polymerization initiator was below 140 °C, the curing reaction proceeded during the film-formation process, and thus, the film could not be applied as an adhesive film. Further, for this reason, experiments for stress relaxation and moisture resistance could not be performed.

In Examples 1 to 10, a resin comprising a C₃₆ structure, which is an alicyclic hydrocarbon with 5 to 8 carbons is substituted by at least 4 alkyl groups of 4 to 12 carbons, stress due to temperature change was relaxed. Thus, curving of the lead frame and chip could be prevented and peeling between the upper surface of the chip and the sealing resin was reduced.

Comparative Example 1 does not contain a resin with a structure in which an alicyclic hydrocarbon with 5 to 8 carbons is substituted by at least 4 alkyl groups of 4 to 12 carbons. Thus, stress due to temperature change could not be relaxed, and the pealing between the upper surface of the chip and the sealing resin could not be reduced.

In Examples 1 to 6, 8, and 9, since most of the resin component consists of a resin with a C₃₆ structure, the moisture content was extremely small, and peeling did not occur in the reflow test even after moisture absorption. In Example 8, even though aluminum nitride, which easily absorbs moisture, was used, moisture resistance sufficient for practical use was shown. Further, since aluminum nitride is a heat conductive filler, it shows an effect of excellent heat conductivity.

In Example 7, since 60% of the resin component consists of a resin with a C₃₆ structure, the moisture content was kept small, and the number of semiconductor devices that peeled could be reduced to 2 or less in the reflow test even after moisture absorption.

Since Example 10 contains a resin with a C₃₆ structure, the moisture content was kept small, and the number of semiconductor devices that peeled could be reduced to half or less in the reflow test even after moisture absorption.

### DESCRIPTION OF NOTATIONS

- 1: substrate
- 2: pressure-sensitive adhesive layer
- 3, 3': adhesive film (thermosetting-type adhesive film)
- 4: semiconductor wafer
- 10, 12: adhesive film with dicing
- 11: dicing film

## Claims

1. An adhesive film, which comprises:
(A) a curable resin with a structure containing an alicyclic hydrocarbon with 5 to 8 carbons, which is substituted by at least 4 alkyl groups of 4 to 12 carbons, which further contains at least one curable part; and
(B) a polymerization initiator with a one-hour half-life temperature of 140°C or higher, wherein (A) comprises the structure shown by the following General Formula (1). General Formula (1) 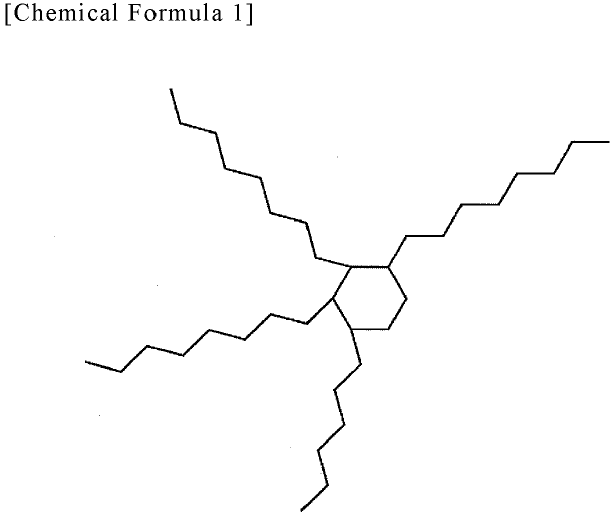 , and wherein the content of (A) is 50% by mass or more of the resin component constituting the film.

2. The adhesive film according to Claim 1, which further comprises a filler.

3. An adhesive film with dicing tape, which comprises the adhesive film according to any one of Claims 1 to 2 laminated on to a dicing tape.

## Patentansprüche

1. Klebefilm, der umfasst:
(A) ein aushärtbares Harz mit einer Struktur, enthaltend einen alizyklischen Kohlenwasserstoff mit 5 bis 8 Kohlenstoffen, der durch mindestens 4 Alkylgruppen mit 4 bis 12 Kohlenstoffen substituiert ist, wobei das Harz ferner mindestens einen aushärtbaren Teil enthält; und
(B) einen Polymerisationsinitiator mit einer Ein-Stunden-Halbwertstemperatur von 140°C oder höher, wobei (A) die Struktur umfasst, die durch die folgende allgemeine Formel (1) dargestellt ist
Allgemeine Formel (1) 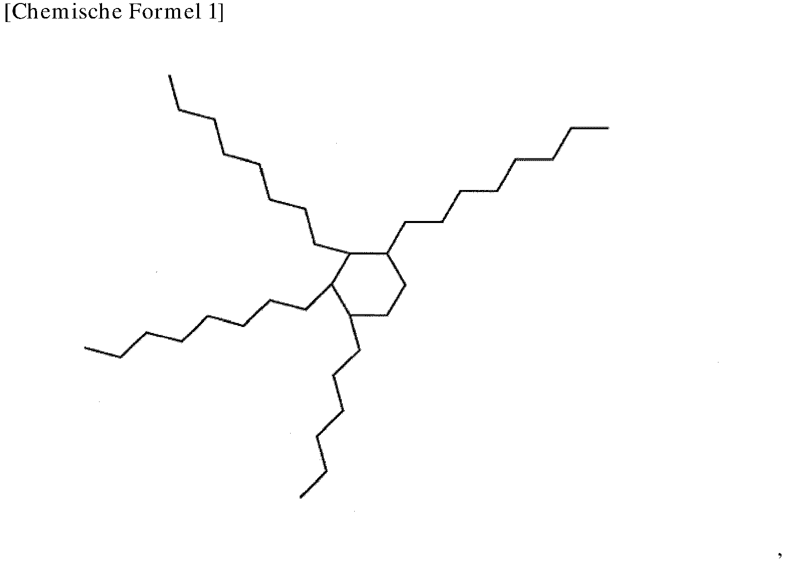 und wobei der Gehalt an (A) 50 Massenprozent oder mehr der Harzkomponente beträgt, welche den Film bildet.

2. Klebefilm nach Anspruch 1, der ferner einen Füllstoff umfasst.

3. Klebefilm mit Sägefolie (dicing tape), der den Klebefilm nach einem der Ansprüche 1 bis 2 umfasst, der auf eine Sägefolie laminiert ist.

## Revendications

1. Film adhésif, qui comprend :
(A) une résine durcissable ayant une structure contenant un hydrocarbone alicyclique ayant de 5 à 8 atomes de carbone, qui est substitué par au moins 4 groupes alkyle de 4 à 12 atomes de carbone, qui contient en outre au moins une partie durcissable ; et
(B) un initiateur de polymérisation avec une température de demi-vie d'une heure de 140 °C ou plus,
dans lequel (A) comprend la structure illustrée par la formule générale (I) suivante Formule générale (1) 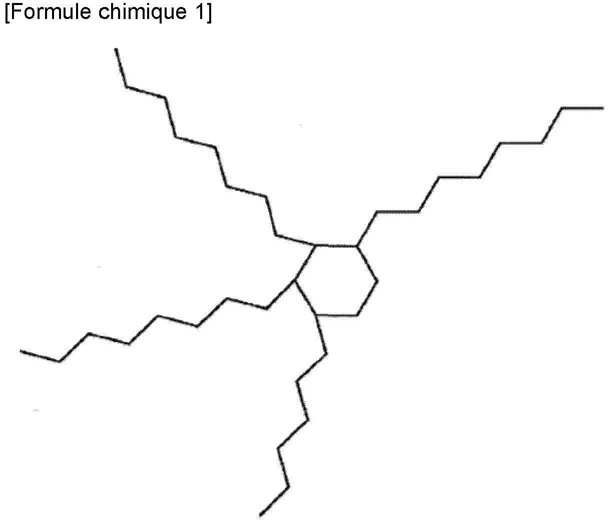 et dans lequel la teneur en (A) est de 50 % en masse ou plus du composant résine constituant le film.

2. Film adhésif selon la revendication 1, qui comprend en outre une charge.

3. Film adhésif avec bande de découpage en dés, qui comprend le film adhésif selon l'une quelconque des revendications 1 à 2 stratifié sur une bande de découpage en dés.
